(19)

Europäisches
Patentamt
European
Patent Office
Office européen
des brevets

(11) **EP 3 686 894 A1**

(12) # EUROPEAN PATENT APPLICATION
published in accordance with Art. 153(4) EPC

(43) Date of publication:
**29.07.2020 Bulletin 2020/31**

(21) Application number: **18807544.4**

(22) Date of filing: **07.06.2018**

(51) Int Cl.:
*G11C 19/28* (2006.01)     *G09G 3/36* (2006.01)

(86) International application number:
**PCT/CN2018/090217**

(87) International publication number:
**WO 2019/056803 (28.03.2019 Gazette 2019/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.09.2017 CN 201710858352**

(71) Applicant: **BOE Technology Group Co., Ltd.**
**Beijing 100015 (CN)**

(72) Inventors:
• **HAN, Mingfu**
  **Beijing 100176 (CN)**

• **SHANG, Guangliang**
  **Beijing 100176 (CN)**
• **HAN, Seung Woo**
  **Beijing 100176 (CN)**
• **YAO, Xing**
  **Beijing 100176 (CN)**
• **ZHENG, Haoliang**
  **Beijing 100176 (CN)**
• **YUAN, Lijun**
  **Beijing 100176 (CN)**
• **WANG, Zhichong**
  **Beijing 100176 (CN)**

(74) Representative: **Klunker IP**
**Patentanwälte PartG mbB**
**Destouchesstraße 68**
**80796 München (DE)**

(54) **SHIFT REGISTER UNIT, GATE DRIVE CIRCUIT, DISPLAY DEVICE AND DRIVE METHOD**

(57)     A shift register unit and a drive method thereof, a gate driving circuit and a display device are provided. The shift register unit (100) includes an input circuit (110), a pull-up node reset circuit (120), an output circuit (130) and a coupling circuit (140). The input circuit (110) is configured to charge a pull-up node (PU) in response to an input signal; the pull-up node reset circuit (120) is configured to reset the pull-up node (PU) in response to a reset signal; the output circuit (130) is configured to output a first clock signal to a first output terminal (OUT1) under control of a level of the pull-up node (PU); and the coupling circuit (140) is configured to control, by coupling, a potential of the pull-up node (PU) in response to a second clock signal. The shift register unit can reduce a falling edge time of the output signal of the first output terminal, thereby improving the driving capability of the shift register unit.

FIG. 3

EP 3 686 894 A1

**Description**

CROSS REFERENCE TO RELATED APPLICATION

The present application claims the priority of Chinese patent application No. 201710858352.4, filed on September 21, 2017, and the entire content disclosed by the Chinese patent application is incorporated herein by reference as part of the present application.

TECHNICAL FIELD

At least one embodiment of the present disclosure relates to a shift register unit and a driving method thereof, a gate driving circuit and a display device.

BACKGROUND

In the field of display technology, for example, a pixel array of a liquid crystal display generally includes rows of gate lines and columns of data lines that intersect with each other. Driving of the gate lines can be implemented by an integrated driving circuit amounted on an array substrate. In recent years, with the continuous improvement of an amorphous silicon thin film process, a gate driving circuit can also be directly fabricated on a thin film transistor array substrate to form a GOA (Gate driver On Array) to drive gate lines.
For example, the GOA formed of a plurality of cascaded shift register units can be used to provide switching voltage signals for the rows of gate lines of a pixel array, thereby controlling the rows of gate lines to be turned on sequentially. Data signals are provided by data lines to the pixel units of a corresponding row in the pixel array in each period, thereby forming gray voltages required for displaying each grayscale of an image, and displaying each frame of the image.

SUMMARY

At least one embodiment of the present disclosure provides a shift register unit, and the shift register unit comprises an input circuit, a pull-up node reset circuit, an output circuit and a coupling circuit. The input circuit is configured to charge a pull-up node in response to an input signal; the pull-up node reset circuit is configured to reset the pull-up node in response to a reset signal; the output circuit is configured to output a first clock signal to a first output terminal under control of a level of the pull-up node; and the coupling circuit is configured to control, by coupling, a potential of the pull-up node in response to a second clock signal.
For example, a shift register unit provided by an embodiment of the present disclosure further comprises a pull-down node control circuit, a pull-up node noise reduction circuit and an output noise reduction circuit. The pull-down node control circuit is configured to control a level of a pull-down node; the pull-up node noise reduction circuit is configured to denoise the pull-up node under control of the level of the pull-down node; and the output noise reduction circuit is configured to denoise the first output terminal under control of the level of the pull-down node.
For example, in a shift register unit provided by an embodiment of the present disclosure, the coupling circuit comprises a first transistor and a storage capacitor. A gate electrode of the first transistor and a first electrode of the storage capacitor are configured to be connected to the pull-up node, a first electrode of the first transistor is configured to be connected to a second clock signal terminal to receive the second clock signal, and a second electrode of the first transistor is configured to be connected to a second electrode of the storage capacitor.
For example, a shift register unit provided by an embodiment of the present disclosure further comprises a second output terminal. The coupling circuit is configured to output the second clock signal to the second output terminal, and the second output terminal is configured to be connected to the second electrode of the first transistor.
For example, a shift register unit provided by an embodiment of the present disclosure further comprises a coupling reset circuit. The coupling reset circuit is configured to reset the second output terminal under control of a level of the pull-down node.
For example, in a shift register unit provided by an embodiment of the present disclosure, the coupling reset circuit comprises a second transistor. A gate electrode of the second transistor is configured to be connected to the pull-down node, a first electrode of the second transistor is configured to be connected to the second output terminal, and a second electrode of the second transistor is configured to be connected to a first voltage terminal to receive a first voltage.
For example, in a shift register unit provided by an embodiment of the present disclosure, the input circuit comprises a third transistor. A gate electrode of the third transistor is connected to a first electrode of the third transistor and the gate electrode of the third transistor is configured to be connected to an input terminal to receive the input signal, and a second electrode of the third transistor is configured to be connected to the pull-up node to charge the pull-up node.

**EP 3 686 894 A1**

For example, in a shift register unit provided by an embodiment of the present disclosure, the pull-up node reset circuit comprises a fourth transistor. A gate electrode of the fourth transistor is configured to be connected to a reset terminal to receive the reset signal, a first electrode of the fourth transistor is configured to be connected to the pull-up node to reset the pull-up node, and a second electrode of the fourth transistor is configured to be connected to a first voltage terminal to receive a first voltage.

For example, in a shift register unit provided by an embodiment of the present disclosure, the output circuit comprises a fifth transistor. A gate electrode of the fifth transistor is configured to be connected to the pull-up node, a first electrode of the fifth transistor is configured to be connected to a first clock signal terminal to receive the first clock signal, and a second electrode of the fifth transistor is configured to be connected to the first output terminal.

For example, in a shift register unit provided by an embodiment of the present disclosure, the pull-down node control circuit comprises a sixth transistor and a seventh transistor. A gate electrode of the sixth transistor is connected to a first electrode of the sixth transistor and the gate electrode of the sixth transistor is configured to be connected to a second voltage terminal to receive a second voltage, and a second electrode of the sixth transistor is configured to be connected to the pull-down node. A gate electrode of the seventh transistor is configured to be connected to the pull-up node, a first electrode of the seventh transistor is configured to be connected to the pull-down node, and a second electrode of the seventh transistor is configured to be connected to a first voltage terminal to receive a first voltage.

For example, in a shift register unit provided by an embodiment of the present disclosure, the pull-up node noise reduction circuit comprises an eighth transistor. A gate electrode of the eighth transistor is configured to be connected to the pull-down node, a first electrode of the eighth transistor is configured to be connected to the pull-up node to denoise the pull-up node, and a second electrode of the eighth transistor is configured to be connected to a first voltage terminal to receive a first voltage.

For example, in a shift register unit provided by an embodiment of the present disclosure, the output noise reduction circuit comprises a ninth transistor. A gate electrode of the ninth transistor is configured to be connected to the pull-down node, a first electrode of the ninth transistor is configured to be connected to the first output terminal, and a second electrode of the ninth transistor is configured to be connected to the first voltage terminal to receive a first voltage.

At least one embodiment of the present disclosure provides a gate driving circuit, the gate driving circuit comprises a plurality of cascaded shift register units according to some embodiments of the present disclosure. Except a first-stage shift register unit, an input terminal of any one of the shift register units of the other stages is connected with a first output terminal of a shift register unit of the preceding stage. Except a last-stage shift register unit, a reset terminal of any one of the shift register units of the other stages is connected with a first output terminal of a shift register of the next stage.

At least one embodiment of the present disclosure provides a gate driving circuit, the gate driving circuit comprises a plurality of cascaded shift register units according to some other embodiments of the present disclosure. Except a first-stage shift register unit, a input terminal of any one of the shift register units of the other stages is connected with a second output terminal of a shift register unit of the preceding stage. Except a last-stage shift register unit, a reset terminal of any one of the shift register units of the other stages is connected with a second output terminal of a shift register of the next stage.

At least one embodiment of the present disclosure provides a display device, the display device comprises a gate driving circuit according to any one of the above-mentioned embodiments of the present disclosure.

At least one embodiment of the present disclosure provides a driving method of the shift register unit, comprising: in a first stage, the input circuit charging the pull-up node in response to the input signal, and the output circuit outputting a low level of the first clock signal to the first output terminal; in a second stage, the potential of the pull-up node being coupled to raise by high levels of the first clock signal and the second clock signal, and the output circuit outputting a high level of the first clock signal to the first output terminal; in a third stage, the potential of the pull-up node being coupled to reduce by the low level of the first clock signal, and the first output terminal being discharged through the output circuit; in a fourth stage, the potential of the pull-up node being further coupled to reduce by a low level of the second clock signal; in a fifth stage, the pull-up node reset circuit resetting the pull-up node under control of the reset signal; and wherein in the third stage and the fourth stage, a falling edge time of the first clock signal is earlier than a falling edge time of the second clock signal.

For example, in a driving method provided by at least one embodiment of the present disclosure, in the second stage, a rising edge time of the first clock signal is consistent with a rising edge time of the second clock signal.

At least one embodiment of the present disclosure provides a driving method of the shift register unit, comprising: in a first stage, the input circuit charging the pull-up node in response to the input signal, the output circuit outputting a low level of the first clock signal to the first output terminal, and the coupling circuit outputting a low level of the second clock signal to the second output terminal; in a second stage, the potential of the pull-up node being coupled to raise by high levels of the first clock signal and the second clock signal, the output circuit outputting a high level of the first clock signal to the first output terminal, and the coupling circuit outputting a high level of the second clock signal to the second output terminal; in a third stage, the potential of the pull-up node being coupled to reduce by the low level of the first

3

clock signal, the first output terminal being discharged to a low level through the output circuit, and the coupling circuit outputting the high level of the second clock signal to the second output terminal; in a fourth stage, the potential of the pull-up node being further coupled to reduce by a low level of the second clock signal, and the second output terminal being discharged to a low level through the coupling circuit; in a fifth stage, the pull-up node reset circuit resetting the pull-up node under control of the reset signal; and wherein in the third stage and the fourth stage, a falling edge time of the first clock signal is earlier than a falling edge time of the second clock signal.

BRIEF DESCRIPTION OF THE DRAWINGS

In order to demonstrate clearly technical solutions of the embodiments of the present disclosure, the accompanying drawings in relevant embodiments of the present disclosure will be introduced briefly. It is apparent that the drawings may only relate to some embodiments of the disclosure and not intended to limit the present disclosure.

FIG. 1 is a circuit diagram of a shift register unit;
FIG. 2 is a signal timing diagram corresponding to an operation process of the shift register unit as shown in FIG. 1;
FIG. 3 is a schematic block diagram of a shift register unit according to an example of an embodiment of the present disclosure;
FIG. 4 is a schematic block diagram of a shift register unit according to another example of an embodiment of the present disclosure;
FIG. 5 is a circuit diagram showing an implementation example of the shift register unit as shown in FIG. 4;
FIG. 6 is a circuit diagram showing an implementation example of the shift register unit as shown in FIG. 3;
FIG. 7 is a signal timing diagram corresponding to an operation process of the shift register unit as shown in FIG. 5;
FIG. 8 is a schematic diagram of emulating potentials of the pull-up node PU in the shift register units as shown in FIG. 1 and FIG. 5;
FIG. 9 is a schematic diagram of emulating output signals of the first output terminal OUT1 in the shift register units as shown in FIG. 1 and FIG. 5;
FIG. 10 is a schematic diagram of a gate driving circuit according to an embodiment of the present disclosure;
FIG. 11 is a schematic diagram of another gate driving circuit according to an embodiment of the present disclosure; and
FIG. 12 is a schematic block diagram of a display device according to an embodiment of the present disclosure.

DETAILED DESCRIPTION

In order to make objects, technical details and advantages of the embodiments of the disclosure apparent, the technical solutions of the embodiment will be described in a clearly and fully understandable way in connection with the drawings related to the embodiments of the disclosure. It is apparent that the described embodiments are just a part but not all of the embodiments of the disclosure. Based on the described embodiments herein, those skilled in the art can obtain other embodiment, without any creative work, which shall be within the scope of the disclosure.

Unless otherwise defined, all the technical and scientific terms used herein have the same meanings as commonly understood by one of ordinary skill in the art to which the present disclosure belongs. The terms, such as "first," "second," or the like, which are used in the description and the claims of the present disclosure, are not intended to indicate any sequence, amount or importance, but for distinguishing various components. The terms, such as "comprise/comprising," "include/including," or the like are intended to specify that the elements or the objects stated before these terms encompass the elements or the objects and equivalents thereof listed after these terms, but not preclude other elements or objects. The terms, such as "connect/connecting/connected," "couple/coupling/coupled" or the like, are not limited to a physical connection or mechanical connection, but may include an electrical connection/coupling, directly or indirectly. The terms, "on," "under," "left," "right," or the like are only used to indicate relative position relationship, and when the position of the object which is described is changed, the relative position relationship may be changed accordingly.

In a display panel technology, in order to realize low cost and narrow bezel, a GOA (Gate driver On Array) technology can be adopted, that is, a gate driving circuit is integrated into the display panel by a thin film transistor process, thereby achieving advantages such as narrow bezel, reducing assembly cost and the like. The display panel can be a liquid crystal display (LCD) panel or an organic light emitting diode (OLED) display panel.

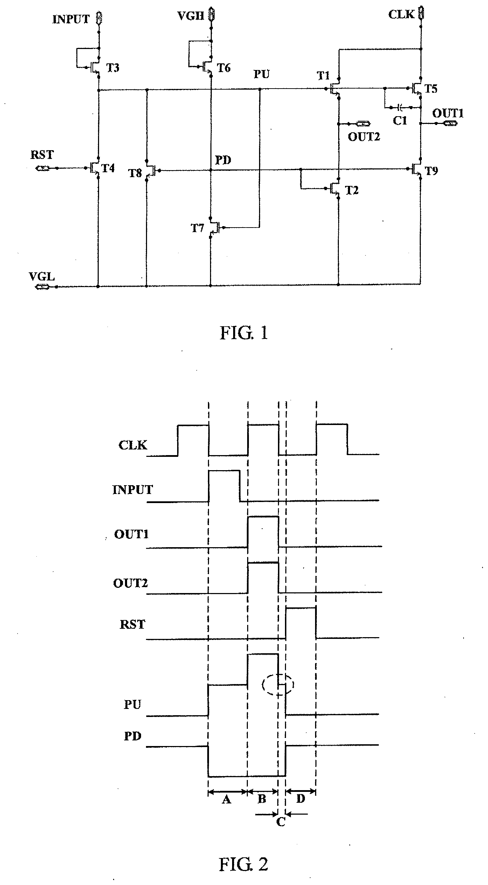

FIG. 1 shows a circuit structure of a shift register unit, and a plurality of the shift register unit can be cascaded to form a gate driving circuit. As shown in FIG. 1, the shift register unit includes nine transistors (T1 to T9) and a storage capacitor (C1).

A gate electrode of a first transistor T1 is connected to a pull-up node PU, a first electrode of the first transistor T1 is connected to a first clock signal terminal CLK, and a second electrode of the first transistor T1 is connected to a second output terminal OUT2.

A gate electrode of a second transistor T2 is connected to a pull-down node PD, a first electrode of the second transistor T2 is connected to the second output terminal OUT2, and a second electrode of the second transistor T2 is connected to a first voltage terminal VGL.

A gate electrode of a third transistor T3 is connected to a first electrode of the third transistor T3, the gate electrode of the third transistor T3 is configured to be connected to an input terminal INPUT, and a second electrode of the third transistor T3 is connected to the pull-up node PU.

A gate electrode of a fourth transistor T4 is connected to an reset terminal RST, a first electrode of the fourth transistor T4 is connected to the pull-up node PU, and a second electrode of the fourth transistor T4 is connected to the first voltage terminal VGL.

A gate electrode of a fifth transistor T5 is connected to the pull-up node PU, a first electrode of the fifth transistor T5 is connected to the first clock signal terminal CLK, and a second electrode of the fifth transistor T5 is connected to a first output terminal OUT1.

A gate electrode of a sixth transistor T6 is connected to a first electrode of the sixth transistor T6, the gate electrode of the sixth transistor T6 is configured to be connected to a second voltage terminal VGH (for example, keep inputting a DC high level signal), and a second electrode of the sixth transistor T6 is connected to the pull-down node PD.

A gate electrode of a seventh transistor T7 is connected to the pull-up node PU, a first electrode of the seventh transistor T7 is connected to the pull-down node PD, and a second electrode of the seventh transistor T7 is connected to the first voltage terminal VGL.

A gate electrode of an eighth transistor T8 is connected to the pull-down node PD, a first electrode of the eighth transistor T8 is connected to the pull-up node PU, and a second electrode of the eighth transistor T8 is connected to the first voltage terminal VGL-(for example, keep inputting a DC low level signal).

A gate electrode of a ninth transistor T9 is connected to the pull-down node PD, a first electrode of the ninth transistor T9 is connected to the first output terminal OUT1, and a second electrode of the ninth transistor T9 is connected to the first voltage terminal VGL.

A first electrode of a storage capacitor C1 is connected to the pull-up node PU, and a second electrode of the storage capacitor C1 is connected to the first output terminal OUT1.

For example, the above-mentioned transistors are all N-type transistors. The following description is also made by taking N-type transistors as an example, but embodiments of the present disclosure are not limited to this case, for example, at least some of these transistors can be replaced with P-type transistors.

The operation principle of the shift register unit as shown in FIG. 1 is described below in combination with a signal timing diagram as shown in FIG. 2. In four stages of a first stage A, a second stage B, a third stage C and a fourth stage D as shown in FIG. 2, the shift register unit performs the following operations.

In the first stage A, the first clock signal terminal CLK is input with a low level signal, and the input terminal INPUT is input with a high level signal. Because the input terminal INPUT is input with a high level signal, the third transistor T3 is turned on, the high level inputted by the input terminal INPUT charges the storage capacitor C1, and a potential of the pull-up node PU is pulled up to a first high level.

For example, the second voltage terminal VGH can be configured to keep inputting an DC high level signal, the sixth transistor T6 remains in a turn-on state, and the high level inputted by the second voltage terminal VGH charges the pull-down node PD. Also, because the potential of the pull-up node PU is at the first high level, the seventh transistor T7 is turned on, thereby enabling the pull-down node PD and the first voltage terminal VGL are electrically connected. In the above case, for example, the first voltage terminal VGL can be configured to keep inputting a DC low level signal. In a design of the transistors, the sixth transistor T6 and the seventh transistor T7 can be configured (for example, size ratios, threshold voltages and the like of the sixth transistor T6 and the seventh transistor T7) when the T6 and the T7 are both turned on, the potential of the pull-down node PD is pulled down to a lower level, which does not cause the eighth transistor T8 to be turned on. It should be noted that the potential level of the signal timing diagram as shown in FIG. 2 is only illustrative and does not represent a true potential value.

Because the pull-up node PU is at the first high level, the first transistor T1 and the fifth transistor T5 are turned on, and in this case, the first clock signal terminal CLK is input with a low level. Therefore, in the first stage A, both of the first output terminal OUT1 and the second output terminal OUT2 output the low level signal.

In the second stage B, the first clock signal terminal CLK is input with a high level signal, and the input terminal INPUT is input with a low level signal. Because the input terminal INPUT is input with a low level signal, the third transistor T3 is turned off, and the pull-up node PU maintains the first high level of the previous stage, thereby enabling the first transistor T1 and the fifth transistor T5 remain in a turn-on state. Because the first clock signal terminal CLK is input with a high level signal in this stage, the first output terminal OUT1 and the second output terminal OUT2 output the high level signal.

Meanwhile, because the first clock signal terminal CLK, the first output terminal OUT1 and the second output terminal OUT2 are at a high level, and the high level can be coupled to raise the potential of the pull-up node PU by parasitic capacitances of the first transistor T1 including a parasitic capacitance between the gate electrode of the first transistor T1 and the first electrode of the first transistor T1, and a parasitic capacitance between the gate electrode of the first transistor T1 and the second electrode of the first transistor T1), parasitic capacitances of the fifth transistor T5 (including a parasitic capacitance between the gate electrode of the fifth transistor T5 and the first electrode of the fifth transistor T5, and a parasitic capacitance between the gate electrode of the fifth transistor T5 and the second electrode of the fifth transistor T5) and the storage capacitor C1. The coupled voltage amplitude of the pull-up node PU can be calculated by equation 1:

$$\Delta V\_PU = \Delta V\_CLK \times (C\_T1 + C\_T5 + C\_C1)/C\_PU ; \qquad \text{(equation 1)}$$

$\Delta V\_PU$ is the coupled voltage amplitude of the pull-up node PU, $\Delta V\_CLK$ is a variable quantity of a voltage amplitude of the first clock signal terminal, $C\_T1$ is a parasitic capacitance value of the first transistor T1, $C\_T5$ is a parasitic capacitance value of the fifth transistor T5, $C\_C1$ is a capacitance value of the storage capacitor C1, and $C\_PU$ is a sum of capacitance values of all the capacitors connected to the pull-up node PU.

The potential of the pull-up node PU is coupled to rise to a second high level, thereby enabling the fifth transistor T5 to be turned on more sufficiently. Because the potential of the pull-up node PU is at a high level, the seventh transistor T7 remains in a turn-on state, enabling the potential of the pull-down node PD continues to remain at a low level. Because the potential of the pull-down node PD is at a low level, the second transistor T2, the eighth transistor T8 and the ninth transistor T9 remain in a turn-off state, thereby not affecting the potential of the pull-up node PU and the shift register unit to normally output a shift signal.

In the third stage C, the signal input by the first clock signal terminal CLK changes from a high level to a low level, and the input terminal INPUT continues to be input with a low level. It is similar to a case that the pull-up node PU is coupled to rise in the second stage, because the signal input by the first clock signal terminal CLK changes to a low level, the potential of the pull-up node PU is coupled to reduce to the first high level (as shown by a dotted oval in FIG. 2), and the voltage amplitude coupled to reduce can still be calculated by the equation 1.

Meanwhile, because the potential of the pull-up node PU is still at a high level, the fifth transistor T5 remains in a turn-on state, and the first output terminal OUT1 is discharged to the first clock signal terminal CLK which is at a low level through the fifth transistor T5. Similarly, the first transistor T1 remains in a turn-on state, and the second output terminal OUT2 is discharged to the first clock signal terminal CLK which is at a low level through the first transistor T1. The potentials of the first output terminal OUT1 and the second output terminal OUT2 are reduced to a low level by the discharging operation.

In the fourth stage D, because the reset terminal RST is input with a high level signal, the fourth transistor T4 is turned on, the pull-up node PU is electrically connected to the first voltage terminal VGL, and the potential of the pull-up node PU is pulled down to a low level, thereby the first transistor T1 and the fifth transistor T5 are turned off.

Because the potential of the pull-up node PU is at a low level, the seventh transistor T7 is turned off, a discharging path of the pull-down node PD is turned off, and the potential of the pull-down node PD is charged to a high level, thereby enabling the eighth transistor T8, the second transistor T2 and the ninth transistor T9 to be turned on. The eighth transistor T8, the second transistor T2 and the ninth transistor T9 respectively pulling down the potentials of the pull-up node PU, the second output terminal OUT2 and the first output terminal OUT1 to a low level which is input by the first voltage terminal VGL, thereby further eliminating noises generated by the output terminals (including the first output terminal OUT1 and the second output terminal OUT2) of the shift register unit and the pull-up node PU of the shift register unit during a non-output stage.

For example, a plurality of the shift register units as shown in FIG. 1 can be cascaded to form a gate driving circuit, and in a case that the gate driving circuit is used to drive a display panel, each stage of the shift register unit corresponds to, for example, one gate line. The first output terminal OUT1 can be connected to a corresponding gate line to provide a progressive scan signal, and the second output terminal OUT2 can be connected to a reset terminal RST of a shift register unit of a previous stage and an input terminal INPUT of a shift register unit of a next stage, thereby separately providing a reset signal and an input signal. Adopting the above-described connection method can improve a load capacity of the shift register unit.

In a case that the shift register unit is in operation and the first output terminal OUT1 is discharged through the fifth transistor T5, because the potential of the pull-up node PU is decreased, the conduction degree of the fifth transistor T5 is affected, thereby affecting the discharge speed of the first output terminal OUT1. The slower the discharge speed of the first output terminal OUT1, the longer the falling edge time of the first output terminal OUT1.

In a high-resolution LCD (Liquid Crystal Display) product, the time available for charging is greatly reduced, for example, for a display product using α-Si (amorphous silicon) TFTs (Thin Film Transistor) as pixel switching elements and having a resolution of 8K, a turn-on time of a row of pixel units is, for example, only 3.7 μs, and the actual effective charging time is less. Therefore, an increase in the charging time of an order of 0.1 $\mu$s can significantly improve a charging rate.

At least one embodiment of the present disclosure provides a shift register unit, and the shift register unit includes an input circuit, a pull-up node reset circuit, an output circuit and a coupling circuit. The input circuit is configured to charge a pull-up node in response to an input signal; the pull-up node reset circuit is configured to reset the pull-up node in response to a reset signal; the output circuit is configured to output a first clock signal to a first output terminal under control of a level of the pull-up node; and the coupling circuit is configured to control, by coupling, a potential of the pull-up node in response to a second clock signal.

At least one embodiment of the present disclosure also provides a gate driving circuit, a display device, and a driving method corresponding to the above-described shift register unit.

The shift register unit, the gate driving circuit, the display device and the driving method provided by the embodiments of the present disclosure can control the potential of the pull-up node by the coupling circuit, enabling the pull-up node can maintain a higher potential when the first output terminal is discharging, thereby reducing the falling edge time of the signal outputted by the first output terminal and increasing the charging time of the pixel units in the display panel, and improving a driving capability.

Hereinafter, embodiments of the present disclosure and examples thereof will be described in detail with reference to the accompanying drawings.

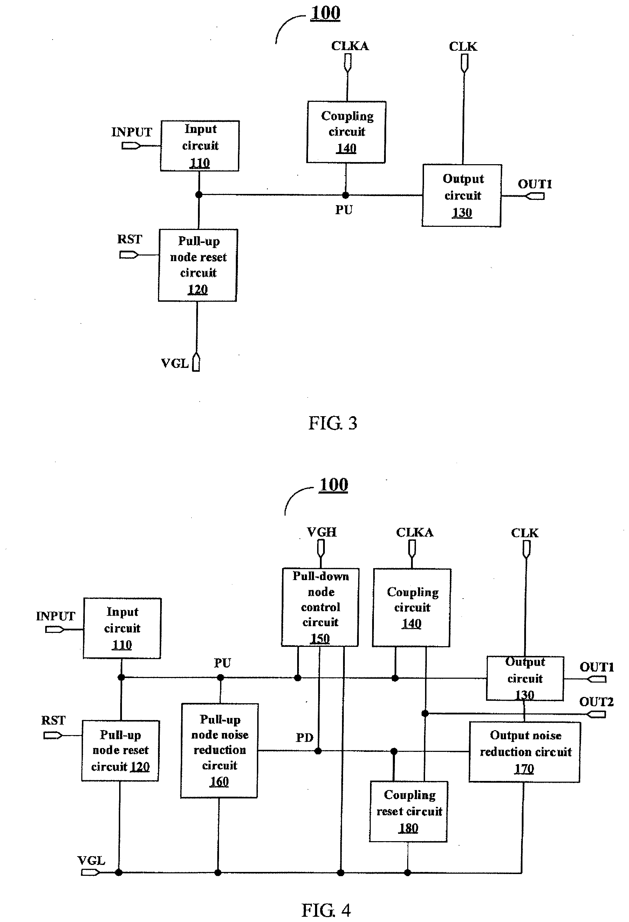

An example of an embodiment of the present disclosure provides a shift register unit 100, as shown in FIG. 3, the shift register unit 100 includes an input circuit 110, a pull-up node reset circuit 120, an output circuit 130 and a coupling circuit 140.

The input circuit 110 is configured to charge a pull-up node PU in response to an input signal. For example, the input circuit 110 can be configured to electrically connect the pull-up node PU and an input terminal INPUT, thereby enabling a high-level signal input by the input terminal INPUT to charge the pull-up node PU.

The pull-up node reset circuit 120 is configured to reset the pull-up node PU in response to a reset signal. For example, the pull-up node reset circuit 120 can be configured to be connected to a reset terminal RST, under control of the reset signal input by the reset terminal RST, the pull-up node PU can be electrically connected to a low-level signal or a low voltage terminal, and the low voltage terminal is, for example, a first voltage terminal VGL, thereby pulling down and resetting the pull-up node PU. It should be noted that the first voltage terminal VGL, for example, can be configured to keep inputting a DC low-level signal, and the embodiments of the present disclosure are the same in this aspect and will not be described again.

The output circuit 130 is configured to output a first clock signal to a first output terminal OUT1 under control of a level of the pull-up node PU. For example, the output circuit 130 can be configured to electrically connect a first clock signal terminal CLK and the first output terminal OUT1 under control of the level of the pull-up node PU, thereby outputting the first clock signal input by the first clock signal terminal CLK to the first output terminal OUT1. At the same time, the first output terminal OUT1 can also be discharged through the output circuit 130.

The coupling circuit 140 is configured to control, by coupling, a potential of the pull-up node PU in response to a second clock signal. For example, the coupling circuit 140 can be connected to a second clock signal terminal CLKA, such that in an event that the second clock signal input by the second clock signal terminal CLKA is at a high level, the coupling circuit 140 coupled control the potential of the pull-up node PU to raise the potential of the pull-up node PU; and in an event that the second clock signal input by the second clock signal terminal CLKA is at a low level, the coupling circuit 140 coupled control the potential of the pull-up node PU to reduce the potential of the pull-up node PU.

For example, a plurality of shift register units 100 can be cascaded to form a gate driving circuit. When a display panel is driven by the gate driving circuit, the potential of the pull-up node PU can be controlled by the output circuit 130, the coupling circuit 140 and a cooperation of the first clock signal and the second clock signal, such that the pull-up node PU maintains a higher potential when the first output terminal OUT1 is discharging, thereby reducing the falling edge time of the signal outputted by the first output terminal OUT1 and increasing the charging time of the pixel units in the display panel, and improving the driving capability.

For example, as shown in FIG. 4, in another example of the present embodiment, the shift register unit 100 can further include a pull-down node control circuit 150, a pull-up node noise reduction circuit 160, and an output noise reduction circuit 170.

The pull-down node control circuit 150 is configured to control a level of the pull-down node PD, and further control the pull-up node noise reduction circuit 160 and the output noise reduction circuit 170.

The pull-up node noise reduction circuit 160 is configured to denoise the pull-up node PU under control of the level of the pull-down node PD. For example, the pull-up node noise reduction circuit 160 can be configured to be connected to the first voltage terminal VGL to electrically connect the pull-up node PU and the first voltage terminal VGL under control of the level of the pull-down node PD, thereby pulling down and denoising the pull-up node PU.

The output noise reduction circuit 170 is configured to denoise the first output terminal OUT1 under control of the level of the pull-down node PU. For example, the output noise reduction circuit 170 can be configured to electrically connect the first output terminal OUT1 and the first voltage terminal VGL under control of the level of the pull-down node PD, thereby pulling down and denoising the first output terminal OUT1.

For example, as shown in FIG. 4, in another example of the present embodiment, the shift register unit 100 can further include a second output terminal OUT2 and a coupling reset circuit 180.

The coupling circuit 140 is also configured to output the second clock signal to the second output terminal OUT2. For example, in an event that a plurality of the shift register units 100 as shown in FIG. 4 are cascaded to form a gate driving circuit, the second output terminal OUT2 can be connected to the reset terminal RST of a shift register unit of a previous stage and the input terminal INPUT of a shift register unit of a next stage, thereby separately providing the reset signal and the input signal. The method of adopting two output terminals can improve the load capacity of the shift register unit.

The coupled reset circuit 180 is configured to reset the second output terminal OUT2 under control of the level of the pull-down node PD. For example, the coupling reset circuit 180 can be configured to be connected to the first voltage terminal VGL to electrically connect the second output terminal OUT2 and the first voltage terminal VGL under control of the level of the pull-down node PD, thereby pulling down and resetting the second output terminal OUT2.

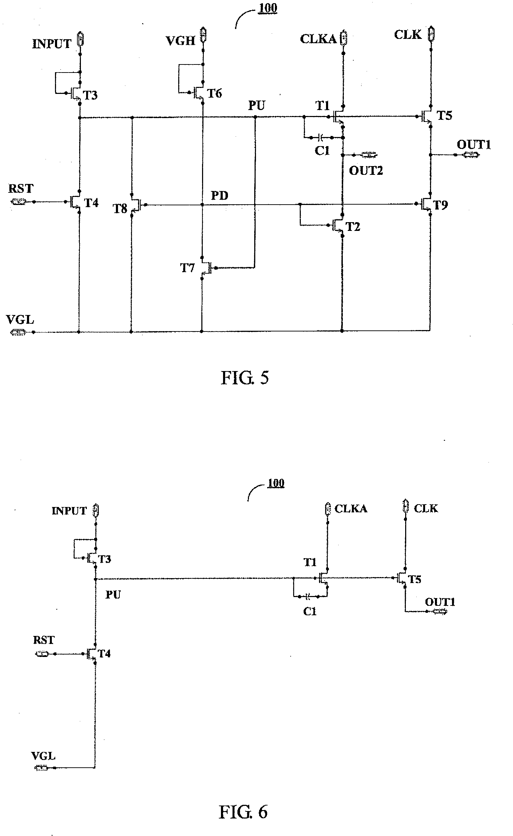

For example, the shift register unit 100 as shown in FIG. 4 can be implemented as the circuit structure as shown in FIG. 5 in an example. As shown in FIG. 5, the shift register unit 100 includes transistors from a first transistor T1 to a ninth transistor T9 and a storage capacitor C1.

As shown in FIG. 5, in this example, in more detail, the coupling circuit 140 can be implemented to include the first transistor T1 and the storage capacitor C1. A gate electrode of the first transistor T1 is configured to be connected to the pull-up node PU, a first electrode of the first transistor T1 is configured to be connected to the second clock signal terminal CLKA to receive the second clock signal, and the second electrode of the first transistor T1 is configured to be connected to the second output terminal OUT2. A first electrode of the storage capacitor C1 is configured to be connected to the pull-up node PU, and a second electrode of the storage capacitor C1 is configured to be connected to the second output terminal OUT2.

The coupling reset circuit 180 can be implemented as a second transistor T2. A gate electrode of the second transistor T2 is configured to be connected to the pull-down node PD, a first electrode of the second transistor T2 is configured to be connected to the second output terminal OUT2, and a second electrode of the second transistor T2 is configured to be connected to the first voltage terminal VGL to receive a first voltage.

It should be noted that, for example, the first voltage terminal VGL in the embodiment of the present disclosure keeps inputting a DC low level signal, and the DC low level is referred to as the first voltage. The second voltage terminal VGH keeps inputting a DC high level, and the DC high level is referred to as the second voltage. The following embodiments are the same as those described herein, which will not be described again.

The input circuit 110 can be implemented as a third transistor T3. A gate electrode of the third transistor T3 is connected to a first electrode of the third transistor T3 and the gate electrode of the third transistor T3 is configured to be connected to the input terminal INPUT to receive the input signal, and a second electrode of the third transistor T3 is configured to be connected to the pull-up node PU to charge the pull-up node PU.

The pull-up node reset circuit 120 can be implemented as a fourth transistor T4. A gate electrode of the fourth transistor T4 is configured to be connected to the reset terminal RST to receive the reset signal, a first electrode of the fourth transistor T4 is configured to be connected to the pull-up node PU to reset the pull-up node PU, and a second electrode of the fourth transistor T4 is configured to be connected to the first voltage terminal VGL to receive the first voltage.

The output circuit 130 can be implemented as a fifth transistor T5. a gate electrode of the fifth transistor T5 is configured to be connected to the pull-up node PU, a first electrode of the fifth transistor T5 is configured to be connected to the first clock signal terminal CLK to receive the first clock signal, and the second electrode of the fifth transistor T5 is configured to be connected to the first output terminal OUT1.

The pull-down node control circuit 150 can be implemented to include a sixth transistor T6 and a seventh transistor T7. A gate electrode of the sixth transistor T6 is connected to a first electrode of the sixth transistor T6 and the gate electrode of the sixth transistor T6 is configured to be connected to the second voltage terminal VGH to receive the second voltage, and a second electrode of the sixth transistor T6 is configured to be connected to the pull-down node PD. A gate electrode of the seventh transistor T7 is configured to be connected to the pull-up node, a first electrode of the seventh transistor T7 is configured to be connected to the pull-down node PD, and a second electrode of the seventh transistor T7 is configured to be connected to the first voltage terminal VGL to receive the first voltage.

The pull-up node noise reduction circuit 160 can be implemented as an eighth transistor T8. A gate electrode of the eighth transistor T8 is configured to be connected to the pull-down node PD, a first electrode of the eighth transistor T8 is configured to be connected to the pull-up node PU to denoise the pull-up node PU, and a second electrode of the eighth transistor T8 is configured to be connected to the first voltage terminal VGL to receive the first voltage.

The output reset circuit 170 can be implemented as a ninth transistor T9. A gate electrode of the ninth transistor T9 is configured to be connected to the pull-down node PD, a first electrode of the ninth transistor T9 is configured to be connected to the first output terminal OUT1, and a second electrode of the ninth transistor T9 is configured to be connected to the first voltage terminal VGL to receive the first voltage.

It should be noted that, for the shift register unit 100 as shown in FIG. 5, the gate electrodes of the second transistor T2 and the ninth transistor T9 cannot be connected to the pull-down node PD, but can be electrically connected to the reset terminal RST, thereby implementing an effect of resetting and denoising under control of the reset signal input by the reset terminal RST, which is not limited in the embodiments of the present disclosure.

For example, the shift register unit 100 as shown in FIG. 3 can be implemented as the circuit structure as shown in FIG. 6. The connection relationship of the respective transistors and the storage capacitor C1 as shown in FIG. 6 can be referred to the corresponding description of the shift register unit 100 as shown in FIG. 5, and details are not described herein again.

It should be noted that the transistors in the embodiments of the present disclosure can adopt thin film transistors, field-effect transistors or other switching devices with the same characteristics. In the embodiments of the present disclosure, thin film transistors are adopted as an example for description. Source electrodes and drain electrodes of the transistors adopted herein can be symmetrical in structure, so the source electrodes and drain electrodes cannot be different structurally. In the embodiment of the present disclosure, in order to distinguish between two electrodes of a transistor other than a gate electrode, it is directly described that one of the two electrodes is a first electrode and the other electrode is a second electrode.

In addition, the transistors in the embodiments of the present disclosure are all described by taking an N-type transistor as an example. In this case, the first electrode can be a drain electrode and the second electrode can be a source electrode. It should be noted that, the embodiments of the present disclosure include, but are not limited to, the examples. For example, one or more switches in the pixel circuit provided in the embodiments of the present disclosure can also adopt P-type thin film transistors. In this case, the first electrode can be a source electrode and the second electrode can be a drain electrode. For a different type of transistor, each electrode of this transistors need to be correspondingly connected with reference to each electrode of the corresponding transistor employed in examples of the embodiments of the present disclosure.

For example, as shown in FIG. 5, each of the transistors in the shift register unit 100 is implemented as an N-type transistor, the first voltage terminal VGL keeps inputting the first voltage at a DC low level, and the second voltage terminal VGH keeps inputting the second voltage at a DC high level. The first clock signal terminal CLK is input with the first clock signal, and the second clock signal terminal CLKA is input with the second clock signal.

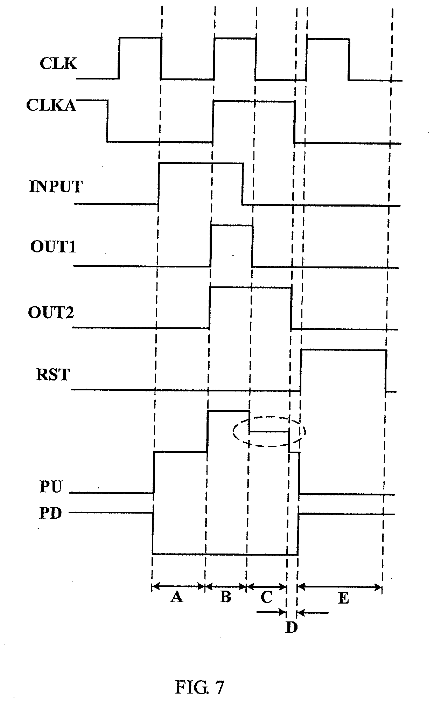

The operation principle of the shift register unit 100 as shown in FIG. 5 is described below in combination with a signal timing diagram as shown in FIG. 7. In five stages of a first stage A, a second stage B, a third stage C, a fifth stage D and a fifth stage E as shown in FIG. 7, the shift register unit 100 performs the following operations.

In the first stage A, the first clock signal terminal CLK is input with a low level signal, the second clock signal terminal CLKA is input with a low level signal, and the input terminal INPUT is input with a high level signal. Because the input terminal INPUT is input with a high level signal, the third transistor T3 is turned on, such that the high level inputted by the input terminal INPUT charges the storage capacitor C1, and a potential of the pull-up node PU is pulled up to a first high level.

Because the second voltage terminal VGH keeps inputting an DC high level signal, the sixth transistor T6 remains in a turn-on state, and a high level inputted by the second voltage terminal VGH charges the pull-down node PD. Also, because the potential of the pull-up node PU is at the first high level, the seventh transistor T7 is turned on, thereby enabling the pull-down node PD and the first voltage terminal VGL are electrically connected. In a design of the transistors, the sixth transistor T6 and the seventh transistor T7 can be configured (for example, size ratios, threshold voltages and the like of the sixth transistor T6 and the seventh transistor T7) when the T6 and the T7 are both turned on, the potential of the pull-down node PD is pulled down to a lower level, which does not cause the eighth transistor T8 and the ninth transistor T9 to be turned on. It should be noted that the potential level of the signal timing diagram as shown in FIG. 7 is only illustrative and does not represent a true potential value.

Because the pull-up node PU is at the first high level, the first transistor T1 and the fifth transistor T5 are turned on, and in this case, the first clock signal terminal CLK and the second clock signal terminal CLKA are input with a low level signal. Therefore, in the first stage A, both of the first output terminal OUT1 and the second output terminal OUT2 output the low level signal.

In the second stage B, the first clock signal terminal CLK is input with a high level signal, the second clock signal terminal CLKA is input with a high level signal, and the signal input by the input terminal INPUT is reduced to a low level after remaining at a high level for a period of time. Because the pull-up node PU is at a high level, enabling the first transistor T1 and the fifth transistor T5 remain in a turn-on state. Because the first clock signal terminal CLK and the second clock signal terminal CLKA are both input with a high level signal in this stage, the first output terminal OUT1 and the second output terminal OUT2 output the high level signal.

Because the first clock signal terminal CLK and the first output terminal OUT1 are at a high level, and the high level can be coupled to raise the potential of the pull-up node PU by parasitic capacitances of the fifth transistor T5 (including a parasitic capacitance between the gate electrode of the fifth transistor T5 and the first electrode of the fifth transistor T5, and a parasitic capacitance between the gate electrode of the fifth transistor T5 and the second electrode of the fifth transistor T5). The voltage amplitude of the pull-up node PU coupled by the high level inputted by the first clock signal terminal CLK can be calculated by equation 2:

$$\Delta V\_PU1 = \Delta V\_CLK \times C\_T5 / C\_PU \qquad \text{(equation 2)}$$

$\Delta V\_PU1$ is the coupled voltage amplitude of the pull-up node PU due to an amount of change in the potential of the first clock signal terminal CLK, $\Delta V\_CLK$ is a variable quantity of the voltage amplitude of the first clock signal terminal, $C\_T5$ is a parasitic capacitance value of the fifth transistor T5, and $C\_PU$ is a sum of capacitance values of all the capacitors connected to the pull-up node PU.

Because the second clock signal terminal CLKA and the second output terminal OUT2 are at a high level, and the high level can be coupled to raise the potential of the pull-up node PU by parasitic capacitances of the first transistor T1 (including a parasitic capacitance between the gate electrode of the first transistor T1 and the first electrode of the first transistor T1, and a parasitic capacitance between the gate electrode of the first transistor T1 and the second electrode of the first transistor T1) and the storage capacitor C1. The voltage amplitude of the pull-up node PU coupled by the high level inputted by the second clock signal terminal CLKA can be calculated by equation 3:

$$\Delta V\_PU2 = \Delta V\_CLKA \times (C\_T1 + C\_C1) / C\_PU \qquad \text{(equation 3)}$$

$\Delta V\_PU2$ is the coupled voltage amplitude of the pull-up node PU due to an amount of change in the potential of the second clock signal terminal CLKA, $\Delta V\_CLKA$ is a variable quantity of the voltage amplitude of the second clock signal terminal, $C\_T1$ is a parasitic capacitance value of the first transistor T1, $C\_C1$ is a capacitance value of the storage capacitor C1, and $C\_PU$ is a sum of capacitance values of all the capacitors connected to the pull-up node PU.

As described above, in the second stage B, the potential of the pull-up node PU is coupled to rise to a second high level by a combined effect of a high level input by the first clock signal terminal CLK and a high level input by the second clock signal terminal CLKA.

The potential of the pull-up node PU is coupled to rise to the second high level, thereby enabling the fifth transistor T5 to be turned on more sufficiently. Because the potential of the pull-up node PU is at a high level, the seventh transistor T7 remains in a turn-on state, enabling the potential of the pull-down node PD continues to remain at a low level. Because the potential of the pull-down node PD is at a low level, the second transistor T2, the eighth transistor T8 and the ninth transistor T9 remain in a turn-off state, thereby not affecting the potential of the pull-up node PU and the shift register unit to normally output a shift signal.

In the third stage C, the signal input by the first clock signal terminal CLK changes from a high level to a low level, and the second clock signal terminal CLKA continues to be input with a high level signal. It is similar to a case that the pull-up node PU is coupled to rise by the high level signal input by the first clock signal terminal CLK in the second stage B. Because the signal input by the first clock signal terminal CLK changes from a high level to a low level in the third stage C, the potential of the pull-up node PU is coupled to reduce a small amplitude to a high level (as shown by a dotted oval in FIG. 7, the high level is greater than the first high level and less than the second high level), and the voltage amplitude coupled to reduce can be calculated by the equation 2.

Because the potential of the pull-up node PU is still at a high level, the fifth transistor T5 remains in a turn-on state, and the first output terminal OUT1 is discharged to the first clock signal terminal CLK which is at a low level through the fifth transistor T5. The potential of the first output terminal OUT1 is reduced to a low level by the discharging operation. Meanwhile, the first transistor T1 remains in a turn-on state, and the second output terminal OUT2 outputs a high level signal which is input from the second clock signal terminal CLKA.

In the fourth stage D, the signal input by the second clock signal terminal CLKA changes from a high level to a low level. It is similar to a case that the pull-up node PU is coupled to rise by the high level signal input by the second clock signal terminal CLKA in the second stage B. Because the signal input by the second clock signal terminal CLKA changes from a high level to a low level in the fourth stage D, the potential of the pull-up node PU is coupled to reduce to the first high level, and the voltage amplitude coupled to reduce can be calculated by the equation 3.

Because the potential of the pull-up node PU is still at a high level, the first transistor T1 remains in a turn-on state, and the second output terminal OUT2 is discharged to the first clock signal terminal CLK which is at a low level through the first transistor T1. The potential of the second output terminal OUT2 is reduced to a low level by the discharging operation.

It can be seen from the equation 2 and the equation 3 that in a case where the parameters of the first transistor T1 and the fifth transistor T5 are determined, hte proportional relationship between ΔV_PU1 and ΔV_PU2 can be adjusted by adjusting the capacitance value C_C1 of the storage capacitor C1, thereby controlling the potential of the pull-up node PU in the third stage C.

In the fifth stage E, because the reset terminal RST is input with a high level signal, the fourth transistor T4 is turned on, the pull-up node PU is electrically connected to the first voltage terminal VGL, and the potential of the pull-up node PU is pulled down to a low level, thereby enabling the first transistor T1 and the fifth transistor T5 to be turned off.

Because the potential of the pull-up node PU is at a low level, the seventh transistor T7 is turned off, a discharging path of the pull-down node PD is turned off, and the potential of the pull-down node PD is charged to a high level, thereby enabling the eighth transistor T8, the second transistor T2 and the ninth transistor T9 to be turned on. The eighth transistor T8, the second transistor T2 and the ninth transistor T9 respectively pulling down the potentials of the pull-up node PU, the second output terminal OUT2 and the first output terminal OUT1 to a low level which is input by the first voltage terminal VGL, thereby further eliminating noises generated by the output terminals (including the first output terminal OUT1 and the second output terminal OUT2) of the shift register unit and the pull-up node PU of the shift register unit during a non-output stage.

Compared with the shift register unit as shown in FIG. 1, in a case that the shift register unit 100 as shown in FIG. 5 is in operation, for example, as shown in FIG. 7, in the third stage C and the fourth stage D, the falling edge time of the signal (the first clock signal) input by the first clock signal terminal CLK is earlier than the falling edge time of the signal (the second clock signal) input by the second clock signal terminal CLKA. With such a timing setting, when the shift register unit 100 is operated in the third stage C, the potential of the pull-up node PU is first decreased by a small amplitude (as shown by a dotted oval in FIG. 7), thereby enabling the potential of the pull-up node PU to be maintained at a higher potential when the first output terminal OUT1 is discharging (compared to the dotted oval in FIG. 2).

It should be noted that, as shown in FIG. 7, in the second stage B, the rising edge time of the signal (the first clock signal) input by the first clock signal terminal CLK is consistent with the rising edge time of the signal (the second clock signal) input by the second clock signal terminal CLKA, and the embodiments of the present disclosure include but are not limited thereto. For example, in an example, the rising edge time of the signal (the first clock signal) input by the first clock signal terminal CLK can also be earlier or later than the rising edge time of the signal (the second clock signal) input by the second clock signal terminal CLKA.

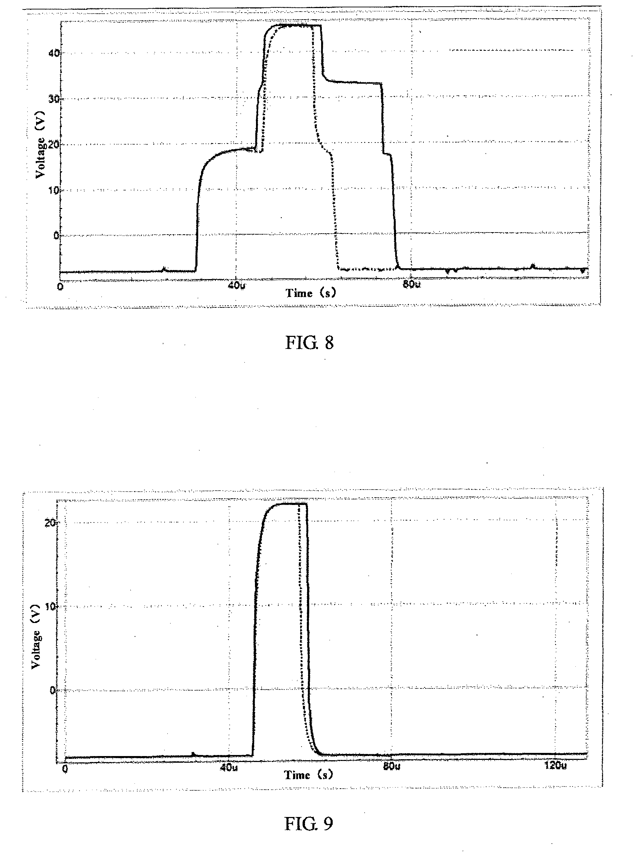

The potential of the pull-up node PU of the shift register unit as shown in FIG. 1 and the potential of the pull-up node PU of the shift register unit as shown in FIG. 5 are simulated, and the simulation results are shown in FIG. 8. The dotted line in FIG. 8 corresponds to the potential of the pull-up node PU in FIG. 1, the solid line in FIG. 8 corresponds to the potential of the pull-up node PU in FIG. 5, the abscissa represents time, and the ordinate represents voltage.

As shown in FIG. 7, in the third stage C, because the potential of the pull-up node PU can be maintained at a higher potential, the high potential can increase the discharge speed of the first output terminal OUT1, thereby reducing the falling edge time of the output signal of the first output terminal OUT1.

It should be noted that the falling edge time of the output signal of the first output terminal OUT1 described in the embodiments of the present disclosure refers to: the time taken for the output signal to fall from 90% of the high level amplitude to 10% of the high level amplitude.

The output signal of the first output terminal OUT1 of the shift register unit as shown in FIG. 1 and the output signal of the first output terminal OUT1 of the shift register unit as shown in FIG. 5 are simulated, and the simulation results are shown in FIG. 9. The dotted line in FIG. 9 corresponds to the output signal of the first output terminal OUT1 in FIG. 1, the solid line corresponds to the output signal of the first output terminal OUT1 in FIG. 5, the abscissa represents time, and the ordinate represents voltage. In a simulation, the falling edge time of the solid line curve is 1.1μs, and the falling edge time of the dotted line curve is 1.8μs. It can be concluded from the simulation results that the falling edge time of the output signal of the first output terminal OUT1 can be reduced by adopting the shift register unit as shown in FIG. 5, thereby increasing the charging time and improving the driving capability.

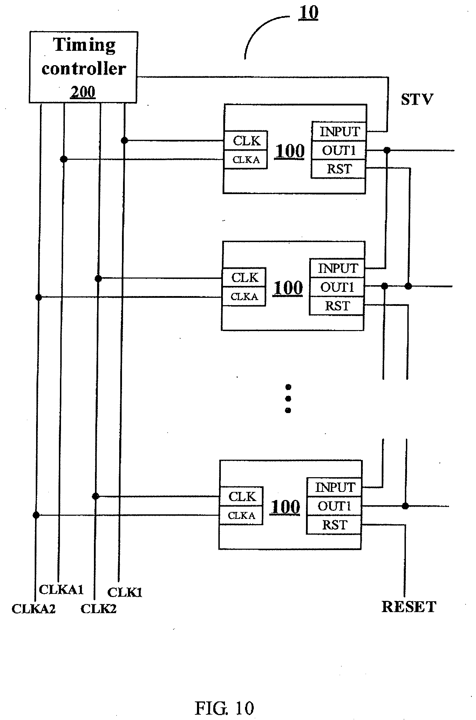

At least one embodiment of the present disclosure also provides a gate driving circuit 10, as shown in FIG. 10, the gate driving circuit 10 includes a plurality of cascaded shift register units 100. For example, the shift register unit 100 can be implemented as the shift register unit provided in the above embodiments, for example, the shift register unit 100 only has the first output terminal OUT1. The gate driving circuit 10 can be directly integrated on an array substrate of a display device by adopting the processes similar to those for forming a thin film transistor, and can realize a function of performing display line by line.

For example, as shown in FIG. 10, except a first-stage shift register unit, an input terminal INPUT of any one of the shift register units of the other stages is connected with a first output terminal OUT1 of a shift register unit of the preceding stage. Except a last-stage shift register unit, a reset terminal RST of any one of the shift register units of the other stages is connected with a first output terminal OUT1 of a shift register of the next stage. For example, the input terminal INPUT of the first-stage shift register unit can be configured to receive a trigger signal STV, and the reset terminal RST of the last-stage shift register unit can be configured to receive a reset signal RESET.

For example, in a case where the gate driving circuit 10 is used to drive a display panel, the gate driving circuit 10 can be disposed on one side of the display panel. For example, the display panel includes N rows of gate lines (N is an integer greater than zero), and the first output terminals OUT1 of each stage of the shift register units 100 in the gate driving circuit 10 can be configured to be sequentially connected to the N rows of gate lines, such that outputting progressive scan signals. It should be noted that the gate driving circuit 10 can be disposed on two sides of the display panel to implement a bilateral driving. The embodiment of the present disclosure does not limit the manner of disposing the gate driving circuit 10, for example, the gate driving circuit 10 can be disposed on one side of the display panel to drive odd rows of grate lines, and the gate driving circuit 10 is disposed on another side of the display panel to drive even rows of grate lines.

For example, as shown in FIG. 10, clock signals can be supplied to the clock signal terminals (the first clock signal terminal CLK and the second clock signal terminal CLKA) in each of the shift register units 100 by four system clock signals CLK1, CLK2, CLKA1 and CLKA2.

For example, as shown in FIG. 10, the gate drive circuit 10 can further include a timing controller 200. The timing controller 200 is configured, for example, to provide the clock signals (CLK1, CLK2, CLKA1, CLKA2) to each stage of the shift register units 100, and the timing controller 200 can also be configured to provide the trigger signal STV and the reset signal RESET.

With the gate driving circuit 10 provided in this embodiment, the falling edge time of the signal outputted by the first output terminal OUT1 can be reduced, thereby increasing the charging time of the pixel units in the display panel and improving the driving capability of the gate driving circuit.

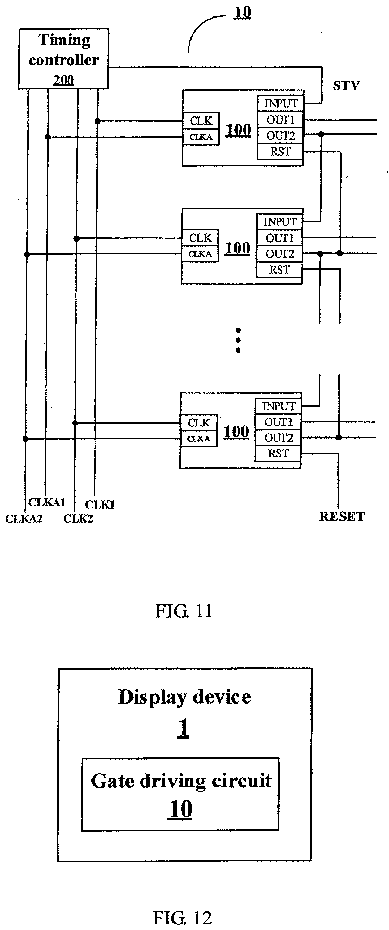

At least one embodiment of the present disclosure further provides a gate driving circuit 10, as shown in FIG. 11, which is different from the gate driving circuit as shown in FIG. 10, the shift register unit 100 adopted by the gate driving circuit 10 in FIG. 11 has the second output terminal OUT2 in addition to the first output terminal OUT1.

For example, as shown in FIG. 11, except a first-stage shift register unit, an input terminal INPUT of any one of the shift register units of the other stages is connected with a second output terminal OUT2 of a shift register unit of the preceding stage. Except a last-stage shift register unit, a reset terminal RST of any one of the shift register units of the other stages is connected with a second output terminal OUT2 of a shift register of the next stage. For example, the input terminal INPUT of the first-stage shift register unit can be configured to receive a trigger signal STV, and the reset terminal RST of the last-stage shift register unit can be configured to receive a reset signal RESET.

In the gate driving circuit 10 provided in this embodiment, same as the previous embodiment, the first output terminals OUT1 of each stage of the shift register units 100 output progressive scan signals, and an output signal of the second output terminal OUT2 can be implemented as a reset signal of the preceding-stage shift register unit and an input signal of the next-stage shift register unit. In this way, the load capacity of the gate driving circuit 10 can be improved.

The other parts and technical effects of the gate driving circuit provided in this embodiment can refer to the corresponding descriptions in the previous embodiment, and details are not described herein again.

At least one embodiment of the present disclosure further provides a display device 1, as shown in FIG. 12, the display device 1 includes any one of the gate driving circuits 10 provided in the above embodiments.

It should be noted that the display device in this embodiment can be a liquid crystal panel, a liquid crystal television, a display, an OLED panel, an OLED television, an electronic paper, a mobile phone, a tablet computer, a notebook computer, a digital photo frame, a navigator and other products or members having display function. The display device 1 further includes other conventional members, such as a display panel, which are not limited by the embodiments of the present disclosure.

The technical effects of the display device 1 provided in the embodiments of the present disclosure can refer to the corresponding descriptions of the shift register units 100 in the above embodiments, and details are not described herein again.

At least one embodiment of the present disclosure further provides a driving method which can be used to drive any one of the shift register units 100 provided in the embodiments of the present disclosure and the gate driving circuit adopting the shift register unit. For example, the driving method includes the following operations.

In a first stage, the input circuit 110 charges the pull-up node PU in response to the input signal, and the output circuit 130 outputs a low level of the first clock signal to the first output terminal OUT1.

In a second stage, the potential of the pull-up node PU is coupled to raise by high levels of the first clock signal and the second clock signal, and the output circuit 130 outputs a high level of the first clock signal to the first output terminal OUT1.

In a third stage, the potential of the pull-up node PU is coupled to reduce by the low level of the first clock signal, and the first output terminal OUT1 is discharged through the output circuit 130.

In a fourth stage, the potential of the pull-up node PU is further coupled to reduce by a low level of the second clock signal.

In a fifth stage, the pull-up node reset circuit 120 resets the pull-up node PU under control of the reset signal.

In the third stage and the fourth stage, a falling edge time of the first clock signal is earlier than a falling edge time of the second clock signal.

It should be noted that, detailed descriptions of the driving method can refer to the descriptions of the operation principle of the shift register unit 100 in the embodiment of the present disclosure, and details are not described herein again.

At least one embodiment of the present disclosure further provides a driving method which can be used to drive the shift register units 100 including the second output terminal OUT2 provided in the embodiments of the present disclosure. For example, the driving method includes the following operations.

In a first stage, the input circuit 110 charges the pull-up node PU in response to the input signal, the output circuit 130 outputs a low level of the first clock signal to the first output terminal OUT1, and the coupling circuit 140 outputs a low level of the second clock signal to the second output terminal OUT2.

In a second stage, the potential of the pull-up node PU is coupled to raise by high levels of the first clock signal and the second clock signal, the output circuit 130 outputs a high level of the first clock signal to the first output terminal OUT1, and the coupling circuit 140 outputs a high level of the second clock signal to the second output terminal OUT2.

In a third stage, the potential of the pull-up node PU is coupled to reduce by the low level of the first clock signal, the first output terminal OUT1 is discharged to a low level through the output circuit 130, and the coupling circuit 140 outputs the high level of the second clock signal to the second output terminal OUT2.

In a fourth stage, the potential of the pull-up node PU is further coupled to reduce by a low level of the second clock signal, and the second output terminal OUT2 is discharged to a low level through the coupling circuit 140.

In a fifth stage, the pull-up node reset circuit 120 resets the pull-up node PU under control of the reset signal.

In the third stage and the fourth stage, a falling edge time of the first clock signal is earlier than a falling edge time of the second clock signal.

It should be noted that, detailed descriptions of the driving method can refer to the descriptions of the operation principle of the shift register unit 100 in the embodiment of the present disclosure, and details are not described herein again.

In the above embodiment, in the second stage, a rising edge time of the first clock signal is consistent with a rising edge time of the second clock signal; or, in the second stage, a rising edge time of the first clock signal is earlier or later than a rising edge of the second clock signal.

The driving method of the shift register unit provided in the embodiment of the present disclosure can reduce the falling edge time of the signal outputted by the first output terminal OUT1 and increase the charging time of the pixel units in the display panel, thereby improving the driving capability.

It should be noted that, in the embodiments of the present disclosure, the high level and the low level input by the respective terminals are described relatively. The high level represents a higher voltage range (for example, the high level can be 5V, 10V or other suitable voltage), and multiple high levels of multiple terminals can be same or different. For example, the high level can turn on an N-type transistor and turn off a P-type transistor. Similarly, the low level represents a lower voltage range (for example, the low level can be 0V, -5V, -10V or other suitable voltage), and multiple low levels of multiple terminals can be same or different. For example, the low level can turn on a P-type transistor and turn off an N-type transistor. For example, a minimum value of the high level is larger than a maximum value of the low level.

What have been described above are only specific implementations of the present disclosure, the protection scope of the present disclosure is not limited thereto. The protection scope of the present disclosure should be based on the protection scope of the claims.

**Claims**

1. A shift register unit, comprising: an input circuit, a pull-up node reset circuit, an output circuit and a coupling circuit;
   wherein the input circuit is configured to charge a pull-up node in response to an input signal;
   the pull-up node reset circuit is configured to reset the pull-up node in response to a reset signal;
   the output circuit is configured to output a first clock signal to a first output terminal under control of a level of the pull-up node; and
   the coupling circuit is configured to control, by coupling, a potential of the pull-up node in response to a second clock signal.

2. The shift register unit according to claim 1, further comprising a pull-down node control circuit, a pull-up node noise reduction circuit and an output noise reduction circuit,
   wherein the pull-down node control circuit is configured to control a level of a pull-down node;
   the pull-up node noise reduction circuit is configured to denoise the pull-up node under control of the level of the pull-down node; and
   the output noise reduction circuit is configured to denoise the first output terminal under control of the level of the pull-down node.

3. The shift register unit according to claim 1 or 2, wherein the coupling circuit comprises a first transistor and a storage capacitor; and
a gate electrode of the first transistor and a first electrode of the storage capacitor are configured to be connected to the pull-up node, a first electrode of the first transistor is configured to be connected to a second clock signal terminal to receive the second clock signal, and a second electrode of the first transistor is configured to be connected to a second electrode of the storage capacitor.

4. The shift register unit according to claim 3, further comprising a second output terminal,
wherein the coupling circuit is configured to output the second clock signal to the second output terminal, and
the second output terminal is configured to be connected to the second electrode of the first transistor.

5. The shift register unit according to claim 4, further comprising a coupling reset circuit,
wherein the coupling reset circuit is configured to reset the second output terminal under control of a level of the pull-down node.

6. The shift register unit according to claim 5, wherein the coupling reset circuit comprises a second transistor,
a gate electrode of the second transistor is configured to be connected to the pull-down node, a first electrode of the second transistor is configured to be connected to the second output terminal, and a second electrode of the second transistor is configured to be connected to a first voltage terminal to receive a first voltage.

7. The shift register unit according to any one of claims 1-6, wherein the input circuit comprises a third transistor,
a gate electrode of the third transistor is connected to a first electrode of the third transistor and the gate electrode of the third transistor is configured to be connected to an input terminal to receive the input signal, and a second electrode of the third transistor is configured to be connected to the pull-up node to charge the pull-up node.

8. The shift register unit according to any one of claims 1-5, wherein the pull-up node reset circuit comprises a fourth transistor,
a gate electrode of the fourth transistor is configured to be connected to a reset terminal to receive the reset signal, a first electrode of the fourth transistor is configured to be connected to the pull-up node to reset the pull-up node, and a second electrode of the fourth transistor is configured to be connected to a first voltage terminal to receive a first voltage.

9. The shift register unit according to any one of claims 1-6, wherein the output circuit comprises a fifth transistor,
a gate electrode of the fifth transistor is configured to be connected to the pull-up node, a first electrode of the fifth transistor is configured to be connected to a first clock signal terminal to receive the first clock signal, and a second electrode of the fifth transistor is configured to be connected to the first output terminal.

10. The shift register unit according to any one of claims 2-5, wherein the pull-down node control circuit comprises a sixth transistor and a seventh transistor,
a gate electrode of the sixth transistor is connected to a first electrode of the sixth transistor and the gate electrode of the sixth transistor is configured to be connected to a second voltage terminal to receive a second voltage, and a second electrode of the sixth transistor is configured to be connected to the pull-down node; and
a gate electrode of the seventh transistor is configured to be connected to the pull-up node, a first electrode of the seventh transistor is configured to be connected to the pull-down node, a second electrode of the seventh transistor is configured to be connected to a first voltage terminal to receive a first voltage.

11. The shift register unit according to any one of claims 2-5, wherein the pull-up node noise reduction circuit comprises an eighth transistor,
a gate electrode of the eighth transistor is configured to be connected to the pull-down node, a first electrode of the eighth transistor is configured to be connected to the pull-up node to denoise the pull-up node, and a second electrode of the eighth transistor is configured to be connected to a first voltage terminal to receive a first voltage.

12. The shift register unit according to any one of claims 2-5, wherein the output noise reduction circuit comprises a ninth transistor,
a gate electrode of the ninth transistor is configured to be connected to the pull-down node, a first electrode of the ninth transistor is configured to be connected to the first output terminal, and a second electrode of the ninth transistor is configured to be connected to a first voltage terminal to receive a first voltage.

**13.** A gate driving circuit, comprising a plurality of cascaded shift register units each of which is according to any one of claims 1-3,
wherein except a first-stage shift register unit, an input terminal of any one of the shift register units of the other stages is connected with a first output terminal of a shift register unit of the preceding stage; and
except a last-stage shift register unit, a reset terminal of any one of the shift register units of the other stages is connected with a first output terminal of a shift register of the next stage.

**14.** A gate driving circuit, comprising a plurality of cascaded shift register units each of which is according to any one of claims 4-6,
wherein except a first-stage shift register unit, an input terminal of any one of the shift register units of the other stages is connected with a second output terminal of a shift register unit of the preceding stage; and
except a last-stage shift register unit, a reset terminal of any one of the shift register units of the other stages is connected with a second output terminal of a shift register of the next stage.

**15.** A display device, comprising the gate driving circuit according to claim 13 or 14.

**16.** A driving method of the shift register unit according to any one of claims 1 to 3, comprising:

in a first stage, the input circuit charging the pull-up node in response to the input signal, and the output circuit outputting a low level of the first clock signal to the first output terminal;
in a second stage, the potential of the pull-up node being coupled to raise by high levels of the first clock signal and the second clock signal, and the output circuit outputting a high level of the first clock signal to the first output terminal;
in a third stage, the potential of the pull-up node being coupled to reduce by the low level of the first clock signal, and the first output terminal being discharged through the output circuit;
in a fourth stage, the potential of the pull-up node being further coupled to reduce by a low level of the second clock signal;
in a fifth stage, the pull-up node reset circuit resetting the pull-up node under control of the reset signal; and
wherein in the third stage and the fourth stage, a falling edge time of the first clock signal is earlier than a falling edge time of the second clock signal.

**17.** The driving method according to claim 16, wherein in the second stage, a rising edge time of the first clock signal is consistent with a rising edge time of the second clock signal.

**18.** A driving method of the shift register unit according to any one of claims 4 to 6, comprising:

in a first stage, the input circuit charging the pull-up node in response to the input signal, the output circuit outputting a low level of the first clock signal to the first output terminal, and the coupling circuit outputting a low level of the second clock signal to the second output terminal;
in a second stage, the potential of the pull-up node being coupled to raise by high levels of the first clock signal and the second clock signal, the output circuit outputting a high level of the first clock signal to the first output terminal, and the coupling circuit outputting a high level of the second clock signal to the second output terminal;
in a third stage, the potential of the pull-up node being coupled to reduce by the low level of the first clock signal, the first output terminal being discharged to a low level through the output circuit, and the coupling circuit outputting the high level of the second clock signal to the second output terminal;
in a fourth stage, the potential of the pull-up node being further coupled to reduce by a low level of the second clock signal, and the second output terminal being discharged to a low level through the coupling circuit;
in a fifth stage, the pull-up node reset circuit resetting the pull-up node under control of the reset signal; and
wherein in the third stage and the fourth stage, a falling edge time of the first clock signal is earlier than a falling edge time of the second clock signal.

FIG. 1

FIG. 2

**100**

CLKA          CLK

INPUT    Input
         circuit
         110

                    Coupling
                    circuit
                    140

                                        Output
                                        circuit          OUT1
                                        130

                         PU

RST     Pull-up
        node reset
        circuit
        120

VGL

FIG. 3

**100**

VGH          CLKA          CLK

INPUT    Input
         circuit
         110

                    Pull-down
                    node
                    control
                    circuit
                    150

                              Coupling
                              circuit
                              140

                         PU

                                                 Output          OUT1
                                                 circuit
                                                 130
                                                                 OUT2

RST     Pull-up         Pull-up
        node reset      node noise      PD
        circuit 120     reduction
                        circuit              Output noise
                        160                  reduction circuit
                                             170

                              Coupling
                              reset circuit
                              180

VGL

FIG. 4

FIG. 5

FIG. 6

18

EP 3 686 894 A1

FIG. 7

FIG. 8

FIG. 9

FIG. 10

FIG. 11

FIG. 12

## INTERNATIONAL SEARCH REPORT

| International application No. |
| --- |
| **PCT/CN2018/090217** |

**A.    CLASSIFICATION OF SUBJECT MATTER**

G11C 19/28(2006.01)i;   G09G 3/36(2006.01)i

According to International Patent Classification (IPC) or to both national classification and IPC

**B.    FIELDS SEARCHED**

Minimum documentation searched (classification system followed by classification symbols)

G11C; G09G

Documentation searched other than minimum documentation to the extent that such documents are included in the fields searched

Electronic data base consulted during the international search (name of data base and, where practicable, search terms used)

CNABS, WPI, EPODOC, CNKI: 京东方, 韩明夫, 移位, 寄存, 输入, 上拉, 下拉, 节点, 复位, 输出, 耦合, 充电, 放电, 时钟, 降噪, 电容, 寄生, 降低, 下降沿, 时间, 提高, 驱动, 能力, shift, register, GOA, input, pull, up, down, node, reset, rst, output, coupl+, discharg+, clock, reduc+, noise, capacitor, time, increas+, driv+, load

**C.    DOCUMENTS CONSIDERED TO BE RELEVANT**

| Category* | Citation of document, with indication, where appropriate, of the relevant passages | Relevant to claim No. |
| --- | --- | --- |
| X | CN 105161134 A (BOE TECHNOLOGY GROUP CO., LTD.) 16 December 2015 (2015-12-16) description, paragraphs [0074]-[0142], and figures 8-9, 13-14 and 17 | 1, 2, 7-13, 15-17 |
| Y | CN 105161134 A (BOE TECHNOLOGY GROUP CO., LTD.) 16 December 2015 (2015-12-16) description, paragraphs [0074]-[0142], and figures 8-9, 13-14 and 17 | 3-6, 14, 18 |
| Y | CN 106952601 A (LG DISPLAY CO., LTD.) 14 July 2017 (2017-07-14) description, paragraphs [0017]-[0057], and figures 1-8 | 3-6, 14, 18 |
| A | CN 103065578 A (BOE TECHNOLOGY GROUP CO., LTD. ET AL.) 24 April 2013 (2013-04-24) entire document | 1-18 |
| A | CN 104392704 A (HEFEI BOE OPTOELECTRONICS TECHNOLOGY CO., LTD. ET AL.) 04 March 2015 (2015-03-04) entire document | 1-18 |

☑ Further documents are listed in the continuation of Box C.          ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **17 August 2018** | **05 September 2018** |

| Name and mailing address of the ISA/CN | Authorized officer |
| --- | --- |
| **State Intellectual Property Office of the P. R. China No. 6, Xitucheng Road, Jimenqiao Haidian District, Beijing 100088 China** | |
| Facsimile No. **(86-10)62019451** | Telephone No. |

Form PCT/ISA/210 (second sheet) (January 2015)

EP 3 686 894 A1

**INTERNATIONAL SEARCH REPORT**

| | International application No. |
|---|---|
| | **PCT/CN2018/090217** |

**C.    DOCUMENTS CONSIDERED TO BE RELEVANT**

| Category* | Citation of document, with indication, where appropriate, of the relevant passages | Relevant to claim No. |
|---|---|---|
| A | CN 106531118 A (BOE TECHNOLOGY GROUP CO., LTD. ET AL.) 22 March 2017 (2017-03-22) entire document | 1-18 |
| A | US 2010245298 A1 (CHEN, YUNGCHIH ET AL.) 30 September 2010 (2010-09-30) entire document | 1-18 |
| A | US 2009041177 A1 (AU OPTRONICS CORP.) 12 February 2009 (2009-02-12) entire document | 1-18 |

Form PCT/ISA/210 (second sheet) (January 2015)

24

**INTERNATIONAL SEARCH REPORT**
Information on patent family members

International application No.

**PCT/CN2018/090217**

| Patent document cited in search report | | | Publication date (day/month/year) | Patent family member(s) | | | Publication date (day/month/year) |
|---|---|---|---|---|---|---|---|
| CN | 105161134 | A | 16 December 2015 | US | 2017345515 | A1 | 30 November 2017 |
| | | | | WO | 2017059791 | A1 | 13 April 2017 |
| CN | 106952601 | A | 14 July 2017 | US | 2017116911 | A1 | 27 April 2017 |
| | | | | KR | 20170049722 | A | 11 May 2017 |
| CN | 103065578 | A | 24 April 2013 | US | 9336898 | B2 | 10 May 2016 |
| | | | | US | 2014169518 | A1 | 19 June 2014 |
| | | | | CN | 103065578 | B | 13 May 2015 |
| | | | | EP | 2743929 | A1 | 18 June 2014 |
| CN | 104392704 | A | 04 March 2015 | US | 2016172054 | A1 | 16 June 2016 |
| CN | 106531118 | A | 22 March 2017 | US | 2018197497 | A1 | 12 July 2018 |
| US | 2010245298 | A1 | 30 September 2010 | TW | I421872 | B | 01 January 2014 |
| | | | | US | 8421781 | B2 | 16 April 2013 |
| | | | | TW | 201035980 | A | 01 October 2010 |
| US | 2009041177 | A1 | 12 February 2009 | TW | I338900 | B | 11 March 2011 |
| | | | | US | 7734003 | B2 | 08 June 2010 |
| | | | | TW | 200908012 | A | 16 February 2009 |

Form PCT/ISA/210 (patent family annex) (January 2015)

**REFERENCES CITED IN THE DESCRIPTION**

**Patent documents cited in the description**

- CN 201710858352